# EUROPEAN PATENT APPLICATION

(11) **EP 3 352 542 A1**
(43) Date of publication of application: **25.07.2018**
(21) Application number: 16846313.1
(22) Date of filing: 06.09.2016
(51) Int. Cl.: H05K 5/02, A45C 5/00, A45C 13/36, G06F 1/16

(54) **HOUSING**

(30) Priority: 18.09.2015 JP 2015185991
(71) Applicant: Toray Industries, Inc., Tokyo 103-8666 (JP)
(72) Inventor: HONMA, Masato, Iyo-gun Ehime 791-3193 (JP); FUJIOKA, Takashi, Iyo-gun Ehime 791-3193 (JP)
(74) Representative: Kador & Partner PartG mbB
(86) International application number: PCT/JP2016/076122
(87) International publication number: WO 2017/047442

(57) **Abstract**

A housing (1) according to a first embodiment of the present invention includes: a bottom cover (2); a top cover (4); and a reinforcing structure (3) that is disposed in a space divided by the bottom cover (2) and the top cover (4), and has a flat portion (31), and a rising wall member (32) erected on a rim of the flat portion (31). The rising wall member (32) of the reinforcing structure (3) is joined to a rising wall member (22) erected on the rim of the bottom cover (2) or the top cover (4).

## Description

### TECHNICAL FIELD

The present invention relates to a housing such as a housing in which an electronic device part is built (electronic device housing), and a housing such as an attache case or a carry case.

### BACKGROUND ART

In recent years, for reducing the thickness and weight of an electronic device, improving the portability of the electronic device, and preventing breakage of components in the electronic device, a housing has been required to have increased rigidity. Specifically, when the electronic device is held with one hand and operated with the other hand, when the electronic device is transported, or when a monitor or the like is opened or closed, a biased load is applied, and therefore a force acts on the housing in a torsion direction. In addition, if the electronic device is dropped by accident during transportation, a force also acts in a torsion direction. Therefore, the housing is required to have high torsional rigidity. In view of such a background, many techniques for increasing the rigidity of a housing have been heretofore proposed. In addition, for reducing the thickness and weight from the viewpoint of improving portability, it is required to utilize a space inside the housing without waste where possible.

Specifically, Patent Document 1 discloses an invention in which a claw portion provided in a first housing is engaged with an engaged portion provided in a second housing, whereby the first housing and the second housing are engaged with each other on a lateral surface. Patent Document 2 discloses an invention for increasing the rigidity of an electric device cabinet structure which includes a resin lower case having upper and lower electric device mounting surfaces, and an upper case having a front wall overlapping the upper electric device mounting surface. Patent Document 3 discloses an invention that relates to a fiber-reinforced composite material structure in which a first surface having a plurality of raised portions and a second surface as a surface material are joined to each other. Patent Document 4 discloses an invention that relates to a bottom plate of a housing frame of an electric device in which a first member and a second member are superposed on each other in the form of a box having a cavity inside, and bonded to each other at a wall surface of a wall portion.

### PRIOR ART DOCUMENT

### PATENT DOCUMENTS

Patent Document 1: Japanese Patent Laid-open Publication No. 2011-22848
Patent Document 2: Japanese Patent Laid-open Publication No. 10-150280
Patent Document 3: Japanese Patent Laid-open Publication No. 2015-13484
Patent Document 4: Japanese Patent Laid-open Publication No. 2002-16384

### SUMMARY OF THE INVENTION

### PROBLEMS TO BE SOLVED BY THE INVENTION

However, in the invention disclosed in Patent Document 1, the claw portion and the engaged portion are not bonded and integrated, and therefore if application of a large load causes torsion, the claw portion or the engaged portion are broken, or the housing is divided into the first housing and the second housing. Resultantly, in the invention disclosed in Patent Document 1, there may be no problem as long as torsional deformation is small enough to maintain an engaged state, but if large torsional deformation occurs due to, for example, accidental falling, original rigidity cannot be secured.

In addition, in the invention disclosed in Patent Document 2, an electric device attachment surface in the upper stage of a resin lower case and a front wall of an upper case are only superposed on each other, and the members are not bound to each other, so that a housing having torsional rigidity required in the market cannot be provided.

In the invention disclosed in Patent Document 3, one member is joined only to a flat surface of the other member, and therefore there is a large difference in rigidity between the front side and the back side. Resultantly, according to the invention disclosed in Patent Document 3, rigidity that is originally required cannot be obtained if the housing is erroneously disposed. Further, since raised portions are formed in the structure, electronic components cannot be packed in the structure, and thus the housing is not suitable for thickness reduction.

In addition, in the invention disclosed in Patent Document 4, the first housing and the second housing are bonded to each other at a wall surface and a flat surface, and therefore high torsional rigidity can be exhibited, as in the case of Patent Document 3, there is a large difference in rigidity between the front side and the back side, so that rigidity that is required originally cannot be obtained if the housing is erroneously disposed. Further, since a truncated shape is protrusively formed in the cavity, the housing is not suitable for thickness reduction because electronic components cannot be packed inside.

As described above, in conventional techniques for increasing the rigidity of the housing, it is not possible to impart high torsional rigidity to the housing while attaining thickness reduction, weight reduction and improvement of portability. Thus, it is expected to provide a technique capable of imparting high torsional rigidity to the housing while attaining thickness reduction and weight reduction.

The present invention has been made in view of the above-described problems, and an object of the present invention is to provide a housing having improved torsional rigidity while having a reduced thickness and weight and improved portability.

### SOLUTIONS TO THE PROBLEMS

A housing according to a first aspect of the present invention includes: a bottom cover; a top cover; and a reinforcing structure that is disposed in a space divided by the bottom cover and the top cover, and has a flat portion, and a rising wall member erected on a rim of the flat portion. The rising wall member of the reinforcing structure is joined to a rising wall member erected on a rim of the bottom cover or the top cover.

In the housing according to the first aspect of the present invention, the rim of the reinforcing structure is joined to the bottom cover or the top cover, and at least a part of a region other than the rim of the reinforcing structure is joined to the bottom cover or the top cover to which the rim of the reinforcing structure is not joined, in the above-described invention.

A housing according to a second aspect of the present invention includes: a bottom cover; a top cover; and a reinforcing structure that is disposed in a space divided by the bottom cover and the top cover, and has a flat portion, and a rising wall member erected on a rim of the flat portion. The rim of the reinforcing structure is joined to the bottom cover or the top cover, and at least a part of a region other than the rim of the reinforcing structure is joined to the bottom cover or the top cover to which the rim of the reinforcing structure is not joined.

In the housing according to the present invention, the reinforcing structure is bonded to the bottom cover and/or the top cover by thermal welding, in the above-described invention.

In the housing according to the present invention, the reinforcing structure is joined to the bottom cover and/or the top cover in such a manner that the peeling load at 23°C is within a range of 60 N/cm² or more and 5000 N/cm² or less, and the peeling load at 200°C is within a range of less than 60 N/cm², in the above-described invention.

In the housing according to the present invention, the reinforcing structure, and the bottom cover and/or the top cover to which the reinforcing structure is joined are formed of a fiber-reinforced composite material, a thermoplastic resin is provided in or on a joining portion of at least one of the reinforcing structure and the bottom cover and/or the top cover, and the reinforcing structure and the bottom cover and/or the top cover are joined with the thermoplastic resin, in the above-described invention.

In the housing according to the present invention, the reinforcing structure and the bottom cover and/or the top cover are directly joined, in the above-described invention.

The housing according to the present invention includes a heat generation member disposed on a surface of the reinforcing structure in the hollow structure formed by joining the reinforcing structure and the bottom cover and/or the top cover, in the above-described invention.

The housing according to the present invention includes another reinforcing structure in the hollow structure formed by joining the reinforcing structure and the bottom cover and/or the top cover, in the above-described invention.

In the housing according to the present invention, the other reinforcing structure is joined to the inner surface of the reinforcing structure, and the bottom cover or the top cover to which the reinforcing structure is joined, in the above-described invention.

### EFFECTS OF THE INVENTION

In the housing according to the present invention, torsional rigidity can be improved while thickness reduction, weight reduction and improvement of portability are attained.

### BRIEF DESCRIPTION OF THE DRAWING

Fig. 1 is a perspective view showing a configuration of a housing according to a first embodiment of the present invention.
Fig. 2 is an exploded perspective view of the housing shown in Fig. 1.
Fig. 3 is a sectional view showing a configuration of a reinforcing structure shown in Fig. 2.
Figs. 4(a) and 4(b) are sectional views showing one example of a configuration of a housing.
Figs. 5(a) and 5(b) show a plan view and a sectional view, respectively, showing a configuration of another reinforcing structure.
Figs. 6(a), 6(b), and 6(c) are schematic views showing a configuration of the reinforcing structure in the housing according to the first embodiment of the present invention.
Fig. 7 is a sectional view showing a configuration of a reinforcing structure in a housing according to a second embodiment of the present invention.
Figs. 8(a) and 8(b) are schematic views for illustrating a torsional rigidity test method.
Fig. 9 is a schematic view for illustrating a deflection rigidity test method.
Fig. 10 is a schematic view for illustrating a peeling load test method.
Fig. 11 is a schematic view showing a configuration of a laminate.
Figs. 12(a) and 12(b) are schematic views for illustrating a press molding method.
Figs. 13(a), 13(b), and 13(c) are schematic views showing an arrangement of a reinforcing structure in Example 1.
Figs. 14(a), 14(b), and 14(c) are schematic views showing an arrangement of a reinforcing structure in Example 5.
Figs. 15(a), 15(b), and 15(c) are schematic views showing an arrangement of a reinforcing structure in Example 6.
Fig. 16 is a sectional view for illustrating thermal welding of a reinforcing structure to a bottom cover in Example 6 using a joining tool.
Figs. 17(a), 17(b), and 17(c) are schematic views showing an arrangement of a reinforcing structure in Example 8.
Fig. 18 is a schematic view showing an arrangement of a reinforcing structure in Example 9.
Fig. 19 is a schematic view showing an arrangement of a reinforcing structure in Example 10.

### EMBODIMENTS OF THE INVENTION

The present inventors have extensively conducted studies, and resultantly found that by joining a reinforcing structure to a housing, the torsional rigidity of the housing can be considerably improved as compared to a case where the reinforcing structure is not joined to the housing. In addition, the present inventors have found that by making use of a hollow structure formed by joining the reinforcing structures, thickness reduction, weight reduction and improvement of portability can be attained. Hereinafter, housings according to first and second embodiments of the present invention, which are conceived from the above-described findings, will be described in detail with reference to the drawings. Examples of the application of the housing of the present invention may include attache cases, carry cases and electronic device housings in which an electronic device component is built, and more specific examples thereof include speakers, displays, HDDs, notebook personal computers, mobile phones, digital still cameras, PDAs, plasma displays, televisions, lighting systems, refrigerator and game machines. In particular, the housing is preferably used for clamshell-type personal computers and tablet-type personal computers which have high torsional rigidity and are required to be light and thin.

### [First Embodiment]

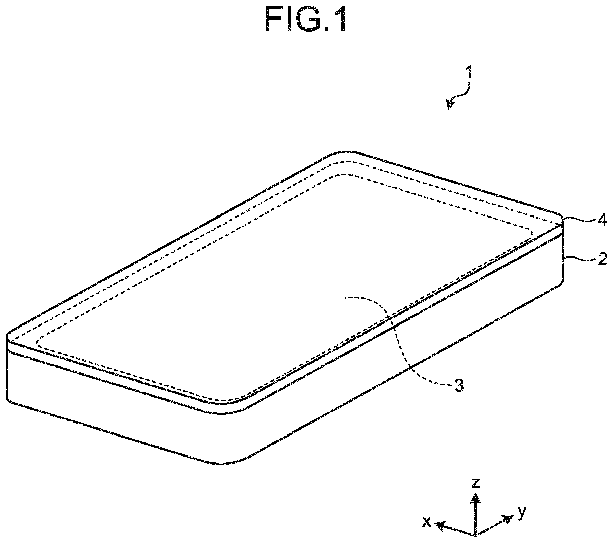

First, a housing according to a first embodiment of the present invention will be described with reference to Figs. 1 to 6.

Fig. 1 is a perspective view showing a configuration of the housing according to the first embodiment of the present invention. As shown in Fig. 1, a housing 1 according to the first embodiment of the present invention includes, as main components, a bottom cover 2 rectangular in plan view, a reinforcing structure 3 joined to the bottom cover 2, and a top cover 4 rectangular in plan view. In the following description, a direction parallel to short sides of the bottom cover 2 and the top cover 4 is defined as an x direction, a direction parallel to long sides of the bottom cover 2 and the top cover 4 is defined as a y direction, and a direction perpendicular to the x direction and the y direction is defined as a z direction (vertical direction).

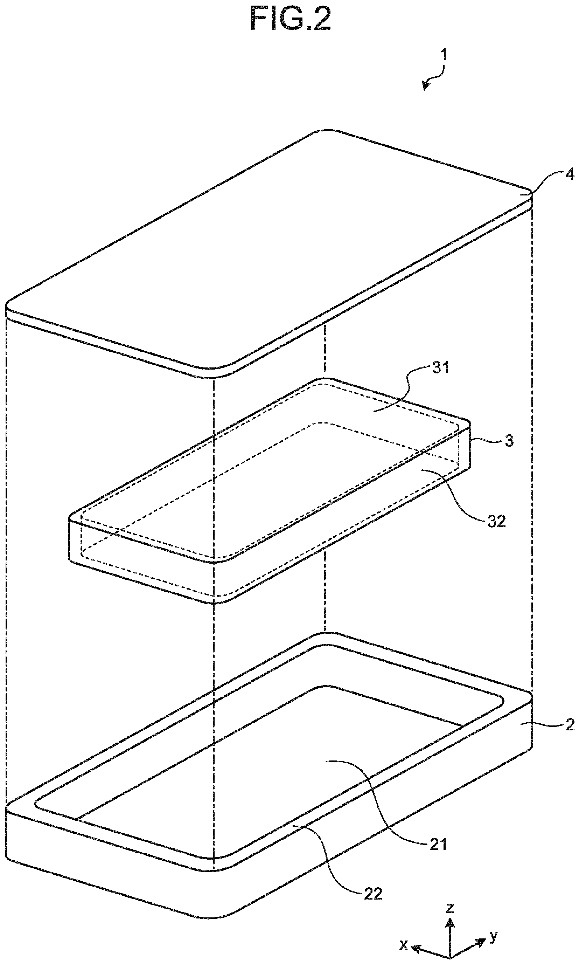

Fig. 2 is an exploded perspective view of the housing 1 shown in Fig. 1. As shown in Fig. 2, the bottom cover 2 includes a flat portion 21 parallel to an x-y plane and rectangular in plan view, and a rising wall member 22 erected in the positive direction of z from a rim of the flat portion 21. The thickness of a member that forms the bottom cover 2 is preferably within a range of 0.1 mm or more and 0.8 mm or less. In addition, the elastic modulus of the member that forms the bottom cover 2 is preferably within a range of 20 GPa or more and 120 GPa or less.

In addition, it is preferable that the bottom cover 2 is formed of any one of a metal material and a fiber-reinforced composite material, and the bottom cover 2 may be formed by combining these materials. From the viewpoint of exhibiting high torsional rigidity, the bottom cover 2 is preferably a seamless member formed of the same material. From the viewpoint of productivity, the flat portion 21 having a simple shape may be formed using the metal material and the fiber-reinforced composite material which have high dynamic characteristics, and the rising wall member 22 and a joining portion which have a complicated shape may be formed by injection molding etc. using a resin material excellent in moldability.

It is preferable to use a light metal material such as an aluminum alloy, a magnesium alloy or a titanium alloy as the metal material. Examples of the aluminum alloy may include A2017 and A2024 as Al-Cu systems, A3003 and A3004 as Al-Mn systems, A4032 as an Al-Si system, A5005, A5052 and A5083 as Al-Mg systems, A6061 and A6063 as Al-Mg-Si systems, and A7075 as an Al-Zn system. Examples of magnesium alloy may include AZ31, AZ61 and AZ91 as Mg-Al-Zn systems. Examples of the titanium alloy may include alloys containing palladium of grades 11 to 23, alloys containing cobalt and palladium, and Ti-6Al-4V corresponding to grade 50 (α alloy), grade 60 (α-β alloy) and grade 80 (β alloy).

As reinforcing fibers to be used in the fiber-reinforced composite material, fibers such as carbon fibers, glass fibers, aramid fibers, boron fibers, PBO fibers, high strength polyethylene fibers, alumina fibers and silicon carbide fibers can be used, and two or more of these fibers may be mixed, and used. These reinforcing fibers can be used as fiber structures such as long fibers aligned in one direction, single tows, woven fabrics, knits, nonwoven fabrics, mats and braided cords.

Examples of the matrix resin that can be used include thermosetting resins such as epoxy resins, phenol resins, benzoxazine resins and unsaturated polyester resins, polyester-based resins such as polyethylene terephthalate (PET), polybutylene terephthalate (PBT), polytrimethylene terephthalate (PTT), polyethylene naphthalate and liquid crystal polyester, polyolefins such as polyethylene (PE), polypropylene (PP) and polybutylene, styrene-based resins, urethane resins, and thermosetting resins such as polyoxymethylene (POM), polyamide (PA), polycarbonate (PC), polymethyl methacrylate (PMMA), polyvinyl chloride (PVC), polyphenylene sulfide (PPS), polyphenylene ether (PPE), modified PPE, polyimide (PI), polyamideimide (PAI), polyether imide (PEI), polysulfone (PSU), modified PSU, polyether sulfone (PES), polyketone (PK), polyether ketone (PEK), polyether ether ketone (PEEK), polyether ketone ketone (PEKK), polyarylate (PAR), polyether nitrile (PEN), phenol-based resins, and phenoxy resins. From the viewpoint of productivity and dynamic characteristics, thermosetting resins are preferably used, and among them, epoxy resins are preferably used. From the viewpoint of moldability, thermoplastic resins are preferably used. Among them, polyamide resins are preferably used from the viewpoint of strength, polycarbonate resins are preferably used from the viewpoint of impact resistance, polypropylene resins are preferably used from the viewpoint of lightness, and polyphenylene sulfide resins are preferably used from the viewpoint of heat resistance. The resin may be used not only as a matrix resin of the fiber-reinforced composite material but also as the bottom cover, the top cover or the reinforcing structure which is composed of a resin itself.

In the present invention, it is preferable that a prepreg including the reinforcing fiber and matrix resin is used as a material of each member from the viewpoint of handling characteristics in lamination etc. From the viewpoints of high dynamic characteristics and design freedom, it is preferable to use unidirectional continuous fiber prepreg, and from the viewpoint of isotropic dynamic characteristics and moldability, it is preferable to use a fabric prepreg. In addition, the reinforcing fiber may be composed of a laminate of these prepregs.

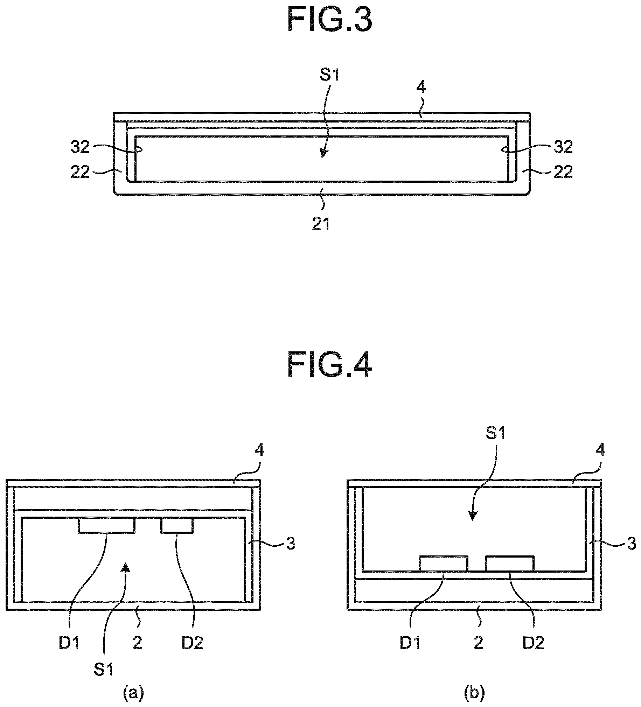

The reinforcing structure 3 includes a flat portion 31 parallel to an x-y plane and rectangular in plan view, and a rising wall member 32 erected in the negative direction of z from a rim of the flat portion 31. Fig. 3 is a sectional view showing a configuration of the reinforcing structure 3 shown in Fig. 2. As shown in Fig. 3, the reinforcing structure 3 is joined to the bottom cover 2 with a hollow structure S1 formed between the flat portion 31 and the flat portion 21 of the bottom cover 2 by plane-joining the outer surface of the rising wall member 32 of the reinforcing structure 3 to the inner surface of the rising wall member 22 of the bottom cover 2.

It is preferable that the rising wall member 32 of the reinforcing structure 3 is plane-joined to the rising wall member 22 on the four sides of the bottom cover 2. In addition, in the present embodiment, the rising wall member 32 of the reinforcing structure 3 is plane-joined to the rising wall member 22 of the bottom cover 2, but the rising wall member may be formed on the top cover 4 side, followed by plane-joining the outer surface of the rising wall member 32 of the reinforcing structure 3 to the inner surface of the rising wall member of the top cover 4. In addition, the maximum value of a distance h between the flat portion 31 of the reinforcing structure 3 and the flat portion 21 of the bottom cover 2 (height of the reinforcing structure 3 from the flat portion 21) is within a range of 3 mm or more and 30 mm or less. In the present invention, the height h of the reinforcing structure 3 is one factor of exhibiting torsional rigidity. Thus, the height h is preferably large, and is preferably 3 mm or more. When the maximum value of the height h is less than 3 mm, there arises the problem that the effect of the rising wall member 32 is low in the housing 1, so that original torsional rigidity cannot be exhibited. On the other hand, when the maximum value of the height h is larger than 30 mm, there arises the problem that it is necessary to increase the thickness of the rising wall member 32, resulting in an increase in weight of the housing 1.

Figs. 4(a) and 4(b) are sectional views showing one example of a configuration of the housing. As shown in Figs. 4(a) and 4(b), heat generation members D1 and D2 are disposed in the hollow structure S1 formed by joining the reinforcing structure 3 and the bottom cover 2 or the top cover 4. It is preferable that the heat generation members D1 and D2 are disposed on a surface of the reinforcing structure 3 on the hollow structure S1 side. With this configuration, the distance between the bottom cover 2 touched by a user of an electronic device and the heat generation members D1 and D2 can be increased to suppress elevation of the temperature of the bottom cover 2. In this specification, the "heat generation member" means a component that generates heat as an electronic device is operated, and particularly refers to a component that causes temperature elevation by 10°C or more as the electronic device is operated. Examples of the heat generation member may include LEDs, capacitors, inverters, reactor elements, thermistor elements, power transistor elements, motors, CPUs, and electronic boards on which these elements are mounted.

In the present invention, it is preferable that another reinforcing structure is provided in the hollow structure S1 formed between the reinforcing structure 3 and the bottom cover 2 or the top cover 4 to which the reinforcing structure 3 is joined. The other reinforcing structure provided in the hollow structure S1 may be joined to only the bottom cover 2 or the top cover 4, or may be joined to only the reinforcing structure 3. Preferably, the other reinforcing structure is joined to the inner surface of the reinforcing structure 3, and also joined to the bottom cover 2 or the top cover 4 to which the reinforcing structure 3 is joined. Here, the inner surface of the reinforcing structure 3 means a surface inside the hollow structure S1 in the reinforcing structure 3.

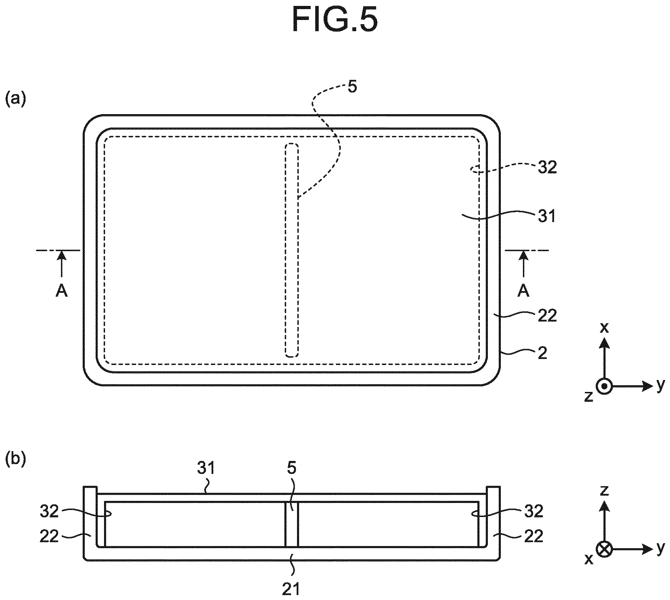

Torsional rigidity may also be increased by disposing another in the hollow structure S1 formed between the flat portion 31 of the reinforcing structure 3 and the flat portion 21 of the bottom cover 2 in such a manner that the inner surface of the reinforcing structure 3 is joined to the bottom cover 2 or the top cover 4 to which the reinforcing structure 3 is joined. Fig. 5(a) is a plan view showing a configuration of another reinforcing structure, and Fig. 5(b) is a sectional view taken along line A-A in Fig. 5(a). As shown in Figs. 5(a) and 5(b), another reinforcing structure 5 is a member disposed so as to extend in the x direction at the central part of the hollow structure S1 in the y direction, and is connected to the flat portion 21 of the bottom cover 2 and the flat portion 31 of the reinforcing structure 3. By integrating the flat portion 21 of the bottom cover 2 and the flat portion 31 of the reinforcing structure 3 with the other reinforcing structure 5 interposed therebetween, the bottom cover 2 and the reinforcing structure 3 are deformed in synchronization with each other if a load is applied, and therefore the deflection rigidity of the housing 1 can be improved. In addition, the rising wall member 22 of the bottom cover 2 and the rising wall member 32 of the reinforcing structure 3 are integrated with the other reinforcing structure 5, and thus the rising wall members 22 and 32 of the bottom cover 2 and the reinforcing structure 3 are hardly deformed particularly inside direction of the housing 1, so that the torsional rigidity of the housing 1 can be improved.

As long as the other reinforcing structure 5 is connected to the flat portion 21 of the bottom cover 2 and the flat portion 31 of the reinforcing structure 3, the other reinforcing structure 5 may be a member disposed so as to extend in the y direction at the central part of the hollow structure S1 in the x direction, or a member disposed so as to extend in the diagonal direction of the hollow structure S1. In particular, it is preferable that the other reinforcing structure 5 is disposed so as to pass through a position at which the amount of deflection of the flat portion 21 of the bottom cover 2 increases when a load is applied in the thickness direction, and a plurality of members may be disposed with the members crossing one another. In addition, it is preferable that the other reinforcing structure 5 is formed of an impact absorbing material excellent in elasticity, such as a resin material having an elastomer or rubber component, or a gel, and accordingly, not only deflection rigidity but also an effect against impact can be exhibited.

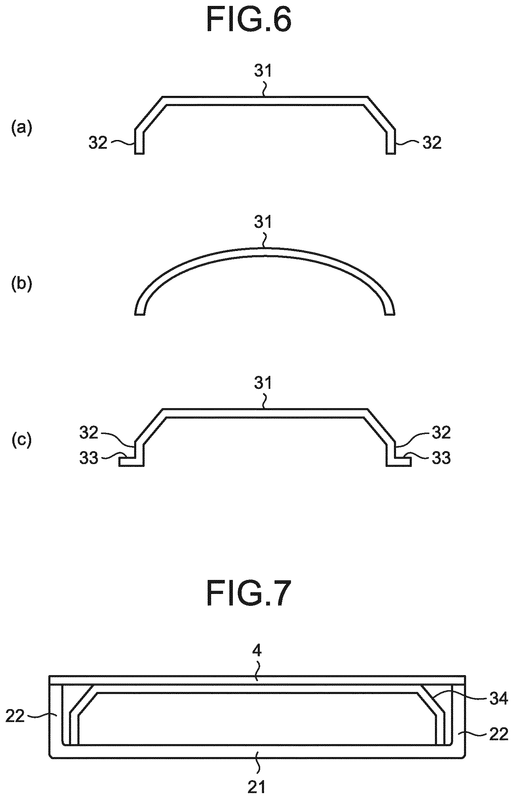

In the present embodiment, the reinforcing structure 3 includes the flat portion 31 and the rising wall member 32 as shown in Fig. 6(a), but the reinforcing structure 3 may be formed with a curved member as the flat portion 31 as shown in Fig. 6(b). That is, a curved member may be used as the flat portion 31, resulting in omission of the rising wall member 32. Further, as shown in Fig. 6(c), the reinforcing structure may include the flat portion 31, the rising wall member 32 and the joint portion 33. In addition, from the viewpoint of increasing rigidity and effectively utilizing the space, an irregular shape may be formed on the flat portion 31. In the present embodiment, the reinforcing structure 3 is joined to the bottom cover 2, but the reinforcing structure 3 may be joined to the top cover 4 to form the hollow structure S1 between the flat portion 31 of the reinforcing structure 3 and the top cover 4. The reinforcing structure 3 is not particularly limited, but is preferably a member having an opening, and one example thereof is the reinforcing structure shown in Figs. 6(a) to 6(c).

In addition, the thickness of the member that forms the reinforcing structure 3 is preferably within a range of 0.3 mm or more and 1.0 mm or less from the viewpoint of reducing the weight and thickness of the housing. In addition, the elastic modulus of the member that forms the reinforcing structure 3 is preferably within a range of 20 GPa or more and 120 GPa or less. In addition, it is preferable that the reinforcing structure 3 is formed of any one of the above-described metal material and fiber-reinforced composite material, and the material can be selected according to the purpose of the reinforcing structure 3. That is, from the viewpoint of exhibiting a high reinforcing effect, it is preferable to use a metal material or fiber-reinforced composite material having a high elastic modulus, and from the viewpoint of heat dissipation, it is preferable to use a metal material having a high thermal conductivity. Further, when the reinforcing structure 3 is formed of a fiber-reinforced composite material, it is preferable that the reinforcing structure 3 is composed of a laminate of unidirectional continuous fiber prepregs. In addition, the ratio of the linear expansion coefficient of the reinforcing structure 3 to the linear expansion coefficient of the bottom cover 2 to which the reinforcing structure 3 is joined is preferably within a range of 0.1 or more and 10 or less.

In addition, it is preferable that the rising wall member 32 of the reinforcing structure 3 is bonded to the rising wall member 22 of the bottom cover 2 by thermal welding. The peeling load at 23°C is more preferably within a range of 100 N/cm² or more and 5000 N/cm² or less. Examples of the thermal welding method may include an insert injection method, an outsert injection method, a vibration welding method, an ultrasonic welding method, a laser welding method and a hot plate welding method. Here, it is preferable that the bonding surface between the rising wall member 32 and the rising wall member 22 has a peeling load of less than 60 N/cm² at 200°C. The peeling load at 200°C is more preferably 30 N/cm² or less.

In addition, this peeling load is preferably less than 60 N/cm² at 180°C, and it is preferable from the viewpoint of disassembling adhesive that the peeling load can be easily peeled off in a lower temperature range. However, when the disassembling temperature lowers, the reinforcing structure may be peeled off temperature elevation associated with operation of an electronic component or depending on the temperature of a use environment in use as a housing. Therefore, it is preferable that in the temperature range where the housing is used, the reinforcing structure is joined with high bonding strength, and in the disassembling temperature range, the reinforcing structure can be easily peeled off. Thus, the peeling load at 80°C is more preferably within a range of 60 N/cm² or more and 5000 N/cm² or less.

The peeling load at 200°C is preferably as low as possible, and most preferably 10 N/cm² or less. Since the peeling load at 200°C is preferably as low as possible, the lower limit thereof is not particularly limited, and is preferably 0 N/cm² or more, but the peeling load at 200°C is more preferably 1 N/cm² or more because when it is excessively low, handling characteristics may be deteriorated. With this configuration, disassembling bondability that makes it possible to easily remove the reinforcing structure 3 can be exhibited, so that repair and recycling of an electronic device can be facilitated. In addition, it is preferable that the reinforcing structure 3, and the bottom cover 2 or the top cover 4 to which the reinforcing structure 3 is joined are formed of a fiber-reinforced composite material, a thermoplastic resin is provided in or on a joining portion of at least one of the reinforcing structure 3 and the bottom cover 2 or the top cover 4, and the reinforcing structure 3 and the bottom cover 2 or the top cover 4 are joined with the thermoplastic resin, in the above-described invention.

As a method for providing a thermoplastic resin on the joining portion, mention is made of a method in which using a fiber-reinforced sheet (prepreg sheet) including a thermoplastic resin as a matrix resin, molding is performed to obtain the reinforcing structure 3, and the bottom cover 2 or the top cover 4 to which the reinforcing structure 3 is joined. A molded product obtained by this method is preferable because a thermoplastic resin is present on a surface of the molded product at a high ratio, and therefore it is possible to secure a wide bonding area in joining, leading to an increase in selection freedom of a joining site. From the viewpoint of the dynamic characteristics of the members, a fiber-reinforced composite material including a thermosetting resin as a matrix resin is preferable, and as a method for providing a thermoplastic resin on such a member, a mention is made of a method in which a molten material obtained by heating and melting a thermoplastic resin or a solution obtained by dissolving a thermoplastic resin in a solvent is applied to provide a thermoplastic resin on the fiber-reinforced composite material. In addition, a mention may be made of, for example, a method in which in molding and curing of a fiber-reinforced sheet (prepreg sheet) including a thermosetting resin as a matrix resin, a laminate in which a film or nonwoven fabric composed of a thermoplastic resin is laminated on a surface is molded under heat and pressure on the outermost layer of the fiber-reinforced sheet (prepreg sheet).

In addition, it is preferable that the reinforcing structure 3 and the bottom cover 2 or the top cover 4 are joined directly. When a fiber-reinforced composite material having a thermoplastic resin is used for the rising wall member 32 of the reinforcing structure 3 and/or the rising wall member 22 of the bottom cover 2 or rising wall member of the top cover 4 that is bonded to the rising wall member 32, it is not necessary to use an adhesive agent other than the members, and the members can be joined directly, so that an increase in weight of the housing 1 can be suppressed. A suitable method for directly joining the reinforcing structure 3 and the bottom cover 2 or the top cover 4 is a method using a laminate, in which a film or nonwoven fabric composed of a thermoplastic resin is laminated on a surface, for the outermost layer of a fiber-reinforced sheet (prepreg sheet) including a thermosetting resin as a matrix resin, and the thermoplastic resin used here can also be selected from the group of thermoplastic resins exemplified as the matrix resin.

Preferably, a thermoplastic resin is selected which has a melting point lower than the molding temperature at which a fiber-reinforced sheet (prepreg sheet) with the matrix resin composed of a thermosetting resin is molded and cured. The lower limit of the melting point of the thermoplastic resin is not particularly limited, but it is preferably 80°C or higher, more preferably 100°C or higher from the viewpoint of exhibiting heat resistance in application of the housing of the present invention to an electronic device. In addition, the form of the thermoplastic resin is not particularly limited, and examples thereof include forms of films, continuous fibers, woven fabrics, particles, nonwoven fabrics and the like, but from the viewpoint of handling characteristics during molding operation, forms of films and nonwoven fabrics are preferable. By selecting such a resin, the thermoplastic resin is melted during molding, and the thermoplastic resin is formed while spreading like a film over a surface of a molded product, so that the bonding area increases during joining, or the reinforcing fibers of the fiber-reinforced sheet are impregnated with the thermoplastic resin to form a strong thermoplastic resin layer, so that high peeling strength can be exhibited. The thermoplastic resin may be provided on at least one of the reinforcing structure 3 obtained in the above-mentioned method and the bottom cover 2 and the top cover 4 joined to the reinforcing structure 3, but it is preferable that the thermoplastic resin is provided on the joining members of both the members to be joined. In addition, it is preferable that substantially the same thermoplastic resin is selected as thermoplastic resins to be provided.

In this specification, the "disassembling adhesive" means that the reinforcing structure 3 can be not only easily removed, but also re-bonded, and in re-bonding, the thermoplastic resin may be provided, but it is preferable that the reinforcing structure can be re-bonded without increasing the weight of the thermoplastic resin or the like. In addition, the peeling load in re-bonding is preferably 50% or more, more preferably 70% or more, of the original peeling load. The disassembling adhesive in the present invention can be attained by applying to a joining technique such characteristics of a thermoplastic resin that the resin is melted by heating to reduce dynamic characteristics, and the resin is solidified by cooling or at normal temperature to exhibit high dynamic characteristics specific to the resin.

In addition, a hole can be formed in each of the flat portion 31 and the rising wall member 32 of the reinforcing structure 3 to the extent that torsional rigidity in the present invention is improved. With such a structure, it is possible to dispose a wiring cable for connecting an electronic component built in the hollow structure S1 to an electronic component disposed in a space (space S3 as described later) other than the hollow structure S1 of the space divided by the bottom cover 2 and the top cover 4, and a display, a key board and so on which correspond to the top cover 4. From the viewpoint of heat dissipation, it is preferable that the hole is disposed to so as to improve the flow of air, e.g. the hole is formed on the opposed rising wall member 32. The area of the holes is preferably 30% or less of the surface area of the reinforcing structure 3, and is more desirably 15% or less of the surface area of the reinforcing structure 3 from the viewpoint of torsional rigidity.

The top cover 4 is joined to the rim of the rising wall member 22 of the bottom cover 2. In Fig. 1, the top cover 4 has a smooth plate shape, but may have a plate shape having a curved surface or irregularities. The material and shape of the top cover 4 may be the same as those of the bottom cover 2, and with this configuration, the housing 1 having high rigidity on either of surfaces thereof can be obtained. In addition, the top cover 4 may be an electronic component such as a liquid crystal display or a keyboard, and with such a configuration, application to a clamshell-type personal computer or a tablet-type personal computer is possible.

As is evident from the above description, the housing 1 according to the first embodiment of the present invention includes: the bottom cover 2; the top cover 4; and the reinforcing structure 3 that is disposed in a space divided by the bottom cover 2 and the top cover 4, and has the flat portion 31, and the rising wall member 32 erected on the rim of the flat portion 31. The rising wall member 32 of the reinforcing structure 3 is joined to the rising wall member erected on the rim of the bottom cover 2 or the top cover 4. Accordingly, there can be provides a housing having improved torsional rigidity while having a reduced thickness and weight.

### [Second Embodiment]

A housing according to a second embodiment of the present invention will now be described with reference to Fig. 7. The housing according to the second embodiment of the present invention is characterized by a configuration of a reinforcing structure. Thus, in the following description, only the configuration of the reinforcing structure in the housing according to the second embodiment of the present invention will be described, and description of other configurations will be omitted.

Fig. 7 is a sectional view showing the configuration of the reinforcing structure in the housing according to the second embodiment of the present invention. In the present embodiment, at least a part of a region other than a rim of a member 34 is joined to a top cover 4 to which the rim of the member 34 is not joined as shown in Fig. 7. In the present embodiment, a rim of the member 34 and at least a part of a region other than the rim are joined to a bottom cover 2 and the top cover 4, respectively, but the rim of the member 34 and at least a part of a region other than the rim may be joined to the top cover 4 and the bottom cover 2, respectively.

As is evident from the above description, the housing 1 according to the second embodiment of the present invention includes: the bottom cover 2; the top cover 4; and the reinforcing structure 3 that is disposed in a space divided by the bottom cover 2 and the top cover 4, and has an opening. The rim of the reinforcing structure 3 is joined to the bottom cover 2, and at least a part of a region other than the rim of the reinforcing structure 3 is joined to the top cover 4 to which the rim of the reinforcing structure 3 is not joined. Accordingly, there can be provides a housing having improved torsional rigidity while having a reduced thickness and weight.

While embodiments of the invention made by the present inventors have been described above, the present invention is not limited by descriptions and drawings constituting a part of the disclosure of the present invention with the embodiments . For example, the housing according to the present invention may be formed by arbitrarily combining the configurations of the housings according to the first and second embodiments. Specifically, the reinforcing structure in the first embodiment may satisfy one or both of the constitutional requirements of the reinforcing structures in the second embodiment, or the reinforcing structure in the second embodiment may satisfy the constitutional requirement of the reinforcing structure in the first embodiment. Thus, other embodiments, examples, operational techniques and the like that are made by those skilled in the art on the basis of the embodiments are all included in the scope of the present invention.

### Examples

Hereinafter, the present invention will be described in detail by way of examples. However, the present invention is not limited to the following examples.

### <Evaluation and Measurement Methods>

### (1) Torsional Rigidity Test

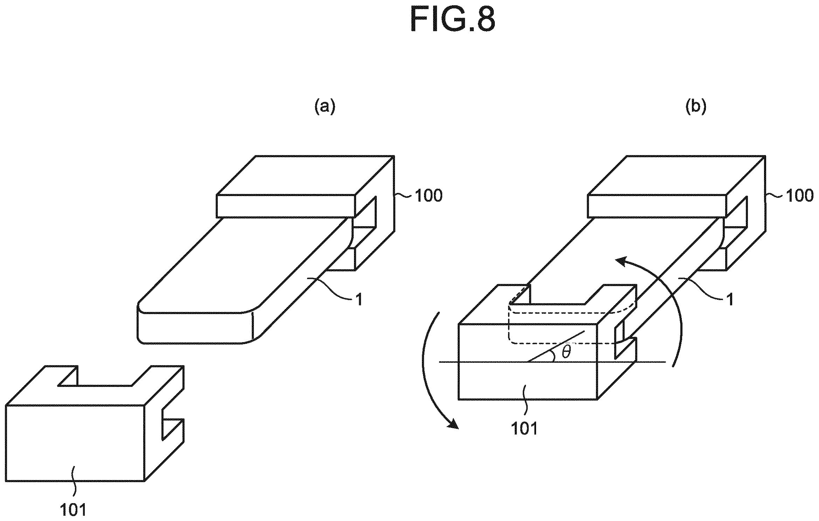

A housing 1 was fixed in a tester in such a manner that one side of the housing 1 was fixed by a U-shaped fixing tool 100, and the other side opposed to the fixed side was held by a support tool 101 as shown in Fig. 8(a), the displacement amount of the housing 1 was then measured when a load of 50 N was applied with a change rate set to 1°/min at an angle θ as shown in Fig. 8(b), and the measured value was defined as a torsional rigidity value of the housing.

### (2) Deflection Rigidity Test

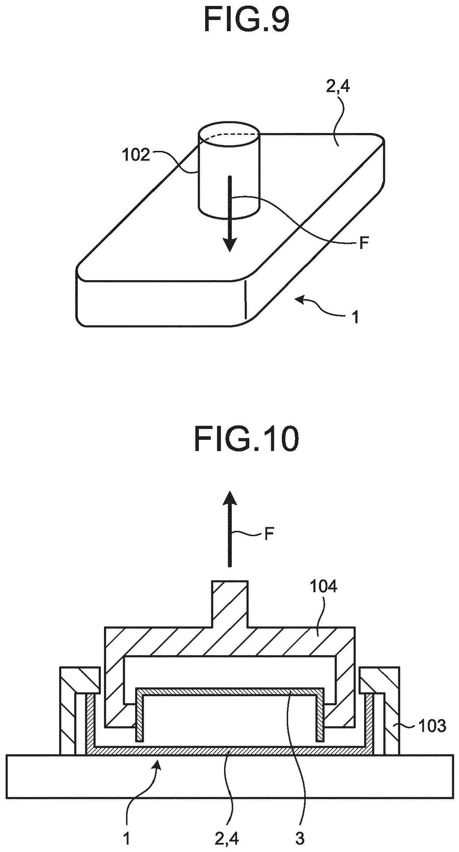

As shown in Fig. 9, the housing was installed in a tester in such a manner that it was able to apply a load F from the side of a bottom cover 2 or a top cover 4 to which a reinforcing structure was joined. "Instron" (registered trademark) Universal Tester Model 4201 (manufactured by Instron Co., Ltd.) was used as a tester. The deflection amount of the bottom cover 2 or the top cover 4 was measured when a load F of 100 N was applied with the housing 1 pressed at the center position at a cross head speed of 1.0 mm/min using an indenter 102 having a diameter of 20 mm, and the measured value was defined as a deflection rigidity value.

### (3) Evaluation of Flexural Modulus

In accordance with the specifications in ASTM D-790 (1997), the flexural moduli of materials to be used for the reinforcing structure 3, the bottom cover 2 and the top cover 4 were evaluated. From each of members obtained in examples and comparative examples, a bending test piece having a width of 25 ± 0.2 mm with a length set to span L + 20 ± 1 mm so that the thickness D and the span satisfied the relationship of L/D = 16 was cut for the four directions: 0°, + 45°, -45° and 90° directions where a certain direction was set to the 0° direction. In this way, test pieces were prepared. The number of measurements (n) in each direction was 5, and the average value of all measured values (n = 20) was defined as a flexural modulus. "Instron" (registered trademark) Universal Tester Model 4201 (manufactured by Instron Co., Ltd.) was used as a tester, a three-point bending test tool (indenter diameter: 10 mm, fulcrum diameter: 10 mm) was used, the support span was set to 16 times of the thickness of the test piece, and the bending elastic modulus was measured. The test was conducted under the following conditions: the moisture content of the test piece was 0.1 mass% or less, the atmospheric temperature was 23°C, and the humidity was 50% by mass.

### (4) Peeling Load Test of Reinforcing Structure (23°C and 200°C)

The peeling load of the reinforcing structure was evaluated in accordance with "Method for Testing Tensile Bonding Strength of Adhesive" specified in JIS K6849 (1994). As test pieces in this test, housings obtained in examples and comparative examples were used. Here, for measuring the peeling strength of the reinforcing structure, evaluation was performed in a state in which there was not a top cover or bottom cover to which the reinforcing structure was not joined (before the reinforcing structure was joined). Specifically, as shown in Fig. 10, the bottom cover 2 or the top cover 4 of the housing 1 was fixed by a fixing tool 103, and the reinforcing structure 3 was fixed by a tensile tool 104. A tensile load F was applied while each member was fixed, and evaluation was performed until the reinforcing structure 3 was peeled off, or the tensile tool 104 was detached from the reinforcing structure 3. The bonding area here was calculated by measuring the width and length of the joining surface of the reinforcing structure 3 before joining. When joining was partially performed, the areas thereof were measured, and summed to determine a joining area. The peeling load of the reinforcing structure 3 was calculated from the resulting tensile load value and joining area. For the peeling load of the reinforcing structure 3 at 200°C, the housing 1 was placed in a thermostat together with the fixing tool, and the atmospheric temperature in the thermostat was elevated to 200°C. After elevation of the temperature, this state was maintained for 10 minutes, and a tensile load was then applied in the same manner as in the peeling load test of the reinforcing structure 3, and evaluation was performed.

### <Materials Used>

Materials used for evaluation are shown below.

### [Material 1]

"TORAYCA" Prepreg P3252S-12 (manufactured by Toray Industries, Inc.) was provided as material 1. The properties of material 1 are shown in Table 1 below.

### [Material 2]

SCF 183 EP-BL 3 manufactured by Super Resin Industry Co., Ltd. was provided as material 2. The properties of material 2 are shown in Table 1 below.

### [Material 3]

An aluminum alloy A5052 was provided as material 3. The properties of material 3 are shown in Table 1 below.

### [Material 4]

A magnesium alloy AZ31 was provided as material 4. The properties of material 4 are shown in Table 1 below.

### [Material 5]

A titanium alloy Ti-6Al-4V was provided as material 5. The properties of material 5 are shown in Table 1 below.

### [Material 6]

Using a master batch including 90% by mass of a polyamide 6 resin ("AMILAN" (registered trademark) CM1021T manufactured by Toray Industries, Inc.) and 10% by mass of a polyamide terpolymer resin composed of polyamide 6/66/610 ("AMILAN" (registered trademark) CM4000 manufactured by Toray Industries, Inc.), a thermoplastic resin film having a basis weight of 124 g/m² was prepared, and provided as material 6. The properties of material 6 are shown in Table 1 below.

**[Table 1]**

| | | Material 1 | Material 2 | Material 3 | Material 4 | Material 5 | Material 6 |
|---|---|---|---|---|---|---|---|
| Material | - | CFRP | GFRP | Al alloy | Mg alloy | Ti alloy | Ny resin |
| Elastic modulus | GPa | 60 | 25 | 70 | 45 | 113 | 3.5 |
| Linear expansion coefficient | 10⁻⁶/°C | 0.3 | 7 | 23.6 | 26 | 8.2 | 83 |
| Thermal conductivity | W/m•K | 3.0 | 0.3 | 236.0 | 159.0 | 22.0 | 0.3 |

### (Example 1)

### Example 1-(1): Preparation of Bottom Cover

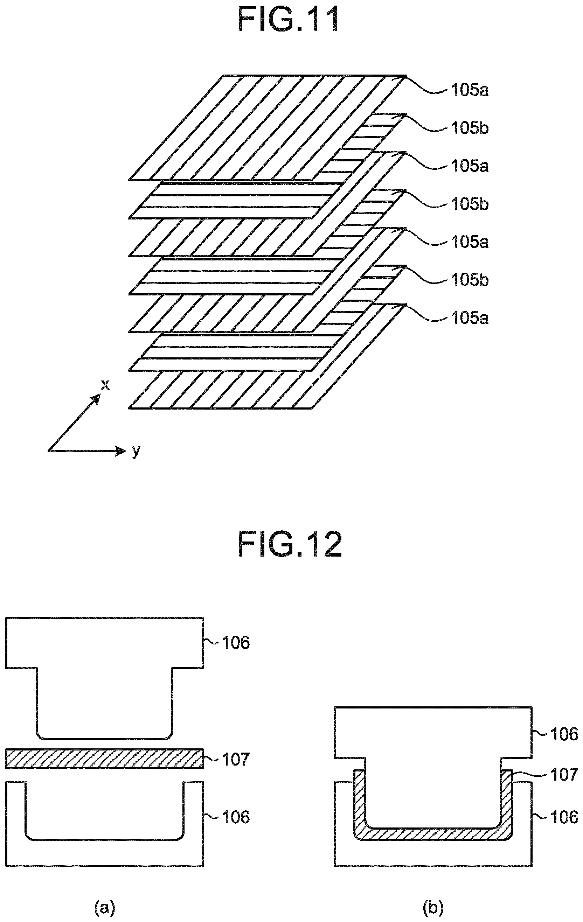

Seven sheets having a predetermined size were cut from material 1. Among them, four sheets were cut in such a manner that the fiber direction of a prepreg was parallel to a longitudinal direction (x direction in Fig. 1), and the other three sheets were cut in such a manner that the fiber direction was parallel to a lateral direction (y direction in Fig. 1). In this example, the lateral direction (y direction) was set to 0°, and as shown in Fig. 11, a laminate including seven prepreg sheets was prepared in such a manner that prepreg sheets 105a with the fiber direction set to 90° and prepreg sheets 105b with the fiber direction set to 0° were symmetrically laminated.

Here, a press molding apparatus and a pair of molds 106 as shown in Fig. 12(a) were used, and the resulting laminate 107 was disposed in a pair of molds 106. Here, the heating platen temperature of the press molding apparatus was set to 150°C, and as shown in Fig. 12(b), the molds 106 were moved, and the laminate was pressurized with the molding pressure kept at 1.0 MPa. After 30 minutes, the molds 106 were opened, and the molded article was removed from the molds 106. Trimming was performed so that the rising wall member of the resulting molded article had a desired height, thereby obtaining a bottom cover.

### Example 1-(2): Preparation of Top Cover

Except that molds configured to prepare a molded article having a smooth shape were used, the same procedure as in Example 1- (1) was carried out to obtain a molded article. Trimming was performed so that the resulting molded article had a desired size, thereby obtaining a top cover.

### Example 1-(3): Preparation of Reinforcing Structure

A molded article was obtained in the same manner as in Example 1-(1). Trimming was performed so that the joining surface of the resulting molded article had a desired width, thereby obtaining a reinforcing structure.

### Example 1-(4): Preparation of Housing

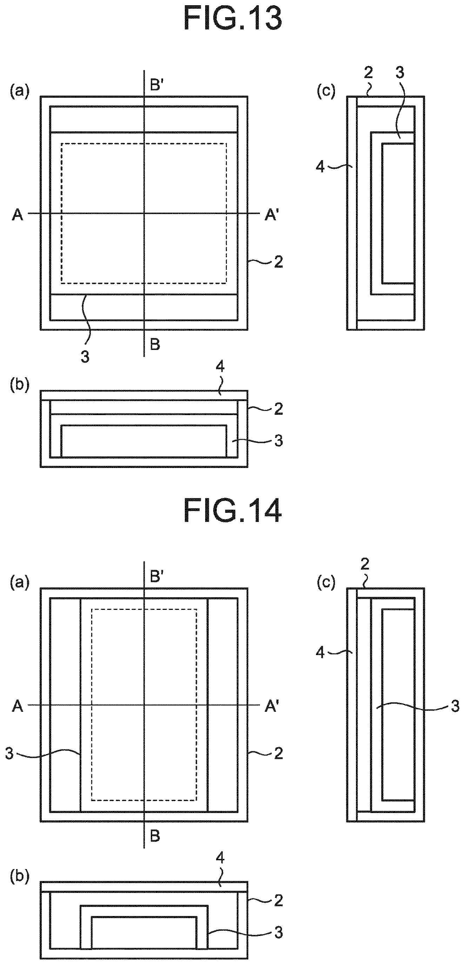

The members obtained in Examples 1-(1) to 1-(3) were joined. Here, as shown in Fig. 13, the rising wall member of the bottom cover 2 in a longitudinal direction (long side) and the rising wall member of the reinforcing structure 3 in a longitudinal direction (long side) were joined to each other with an adhesive. The molding conditions and evaluation results in Example 1 are shown in Table 2 below.

### (Example 2)

Rather than an adhesive, a molten hot melt resin (HM712 manufactured by Cemedine Co., Ltd.) was applied by a hot melt applicator at 140°C, a reinforcing structure was superposed thereon, a weight was placed on the reinforcing structure, and this state was kept for 3 minutes. Except for the method for joining, the same procedure as in Examples 1-(1) to 1-(4) was carried out to obtain a housing. The molding conditions and evaluation results in Example 2 are shown in Table 2 below.

### (Examples 3 and 4)

Except that a reinforcing structure having a size as described in Table 2 was molded and used, the same procedure as in Example 2 was carried out to obtain a housing. The molding conditions and evaluation results in Examples 3 and 4 are shown in Table 2 below.

### (Example 5)

Except that a reinforcing structure having a size as described in Table 3 was molded and used, and as shown in Fig. 14, the rising wall member of the bottom cover 2 in a lateral direction (short side) and the rising wall member of the reinforcing structure 3 in a lateral direction (short side) were joined to each other by thermal welding, the same procedure as in Example 2 was carried out to obtain a housing. The molding conditions and evaluation results in Example 5 are shown in Table 3 below.

### (Example 6)

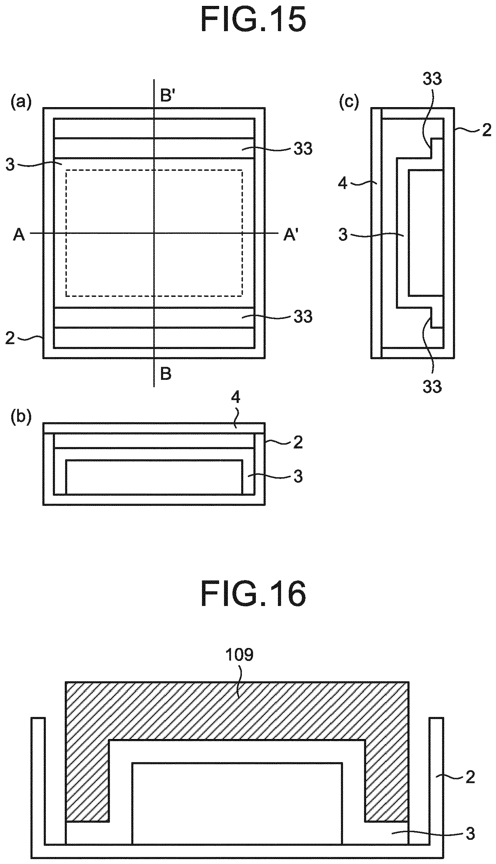

A film composed of a polyamide copolymer ("AMILAN" (registered trademark) CM8000 manufactured by Toray Industries, Inc.) and having a thickness of 50 µm was laminated on a surface of a bottom cover, which is joined to the reinforcing structure, and a surface of the reinforcing structure, which is joined to the bottom cover. In this manner, a laminate was obtained. The resulting laminate was used to obtain a reinforcing structure and a bottom cover in which the reinforcing structure 3 was provided with an overlap width 33 with the bottom cover 2 as shown in Fig. 15. A joining tool 109 as shown in Fig. 16 was provided, and the joined bottom cover and reinforcing structure were disposed, and heated and pressurized in a press molding apparatus set so that the joining tool 109 had a surface temperature of 180°C. After 1 minute, the bottom cover, the reinforcing structure and the joining tool were taken out from the press molding apparatus, and cooled. After 5 minutes, the joining tool 109 was removed to obtain an integrated product of the bottom cover and the reinforcing structure. Thereafter, the top cover was joined using an adhesive in the same manner as in Example 1-(4). The molding conditions and evaluation results in Example 6 are shown in Table 3 below.

### (Example 7)

As another reinforcing structure, 25 sheets of material 1 were laminated so as to have a thickness of 3 mm with 0° prepreg sheets and 90° prepreg sheets being symmetrically laminated in an alternate manner. In the same manner as in Example 1-(1), the laminate was heated and pressurized by a press molding apparatus to obtain a molded article. The resulting molded article was processed so as to have a width of 7.2 mm, thereby obtaining another reinforcing structure having a size as shown in Table 3. The resulting another reinforcing structure was disposed as shown in Fig. 5, and joined by an adhesive, and subsequently the same procedure as in Example 2 to obtain a housing. The molding conditions and evaluation results in Example 7 are shown in Table 3 below.

### (Example 8)

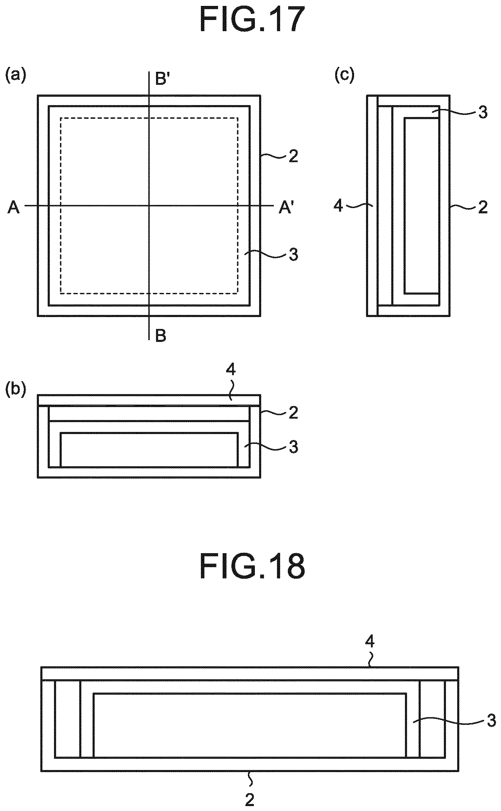

Except that a reinforcing structure having a size as described in Table 3 was molded and used, and as shown in Fig. 17, the rising wall member of the bottom cover 2 in a lateral direction (short side) and the rising wall member of the bottom cover 2 in a longitudinal direction (long side) were joined to the rising wall member of the reinforcing structure 3 in a lateral direction (short side) and the rising wall member of the reinforcing structure 3 in a longitudinal direction (long side) by thermal welding, the same procedure as in Example 2 was carried out to obtain a housing. The molding conditions and evaluation results in Example 8 are shown in Table 3 below.

### (Example 9)

Except that a reinforcing structure having a size as described in Table 4 was molded and used, and as shown in Fig. 18, the flat portion 31 of the reinforcing structure 3 was plane-joined to the top cover 4, the same procedure as in Example 2 was carried out to obtain a housing. The molding conditions and evaluation results in Example 9 are shown in Table 4 below.

### (Example 10)

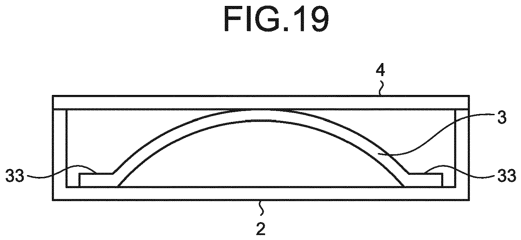

Except that a reinforcing structure having a size as described in Table 4 was molded and used, and as shown in Fig. 19, the reinforcing structure 3 was provided with an overlap width 33 with the bottom cover 2, and the upper part of the reinforcing structure 3 was joined to the top cover 4, the same procedure as in Example 6 was carried out to obtain a housing. The molding conditions and evaluation results in Example 10 are shown in Table 4 below.

### (Example 11)

Except that a reinforcing structure having a size as described in Table 4 was molded and used, and as shown in Fig. 18, the flat portion 31 of the reinforcing structure 3 was plane-joined to the top cover 4, and the rising wall member of the bottom cover 2 in a longitudinal direction (long side) and the rising wall member of the reinforcing member 3 in a longitudinal direction (long side) were joined to each other by thermal welding, the same procedure as in Example 2 was carried out to obtain a housing. The molding conditions and evaluation results in Example 11 are shown in Table 4 below.

### (Example 12)

Except that as the bottom cover, a material as described in Table 4 was used, the heating platen temperature was 220°C, and the molding pressure was 10 MPa, the same procedure as in Example 2 was carried out to obtain a housing. The molding conditions and evaluation results in Example 12 are shown in Table 4 below.

### (Example 13)

Except that as the bottom cover, a material as described in Table 4 was used, the heating platen temperature was 200°C, and the molding pressure was 10 MPa, the same procedure as in Example 2 was carried out to obtain a housing. The molding conditions and evaluation results in Example 13 are shown in Table 5 below.

### (Example 14)

Except that as the bottom cover, a material as described in Table 4 was used, the heating platen temperature was 240°C, and the molding pressure was 10 MPa, the same procedure as in Example 2 was carried out to obtain a housing. The molding conditions and evaluation results in Example 14 are shown in Table 5 below.

### (Example 15)

Except that as the bottom cover, a material as described in Table 4 was used, the same procedure as in Example 2 was carried out to obtain a housing. The molding conditions and evaluation results in Example 15 are shown in Table 5 below.

### (Example 16)

Except that a reinforcing structure as described in Table 5 was molded and used, the same procedure as in Example 2 was carried out to obtain a housing. The molding conditions and evaluation results in Example 16 are shown in Table 5 below.

### (Example 17)

Except that a bottom cover and a top cover as described in Table 6 were molded and used, the same procedure as in Example 2 was carried out to obtain a housing. The molding conditions and evaluation results in Example 17 are shown in Table 6 below.

### (Example 18)

Except that a reinforcing structure as described in Table 6 was molded and used, the same procedure as in Example 2 was carried out to obtain a housing. The molding conditions and evaluation results in Example 18 are shown in Table 6 below.

### (Example 19)

### Example 19-(1): Preparation of Bottom Cover

A laminate obtained by laminating 10 sheets of material 6, a press molding apparatus, and a pair of molds 106 as shown in Fig. 12(a) were used. The laminate was disposed in a pair of molds 106. Here, the heating platen temperature of the press molding apparatus was set to 260°C, and the laminate was pressurized with the molding pressure kept at 1.0 MPa. After 10 minutes, cooling water was made to pass through the heating plate, so that cooling was started. After the temperature of the molds 106 decreased to 100°C or lower, the molds 106 were opened, and a molded article was taken out from the molds 106. Trimming was performed so that the rising wall member of the resulting molded article had a desired height, thereby obtaining a bottom cover.

### Example 19-(2): Preparation of Reinforcing Structure and Top Cover

Except that the mold to be used was changed so as to attain a size as described in Table 6, the same procedure as in Example 19-(1) was carried out to obtain a reinforcing structure and a top cover.

### Example 19-(3): Preparation of Housing

The resulting bottom cover and reinforcing structure were superposed on each other in a joined form, and joined using an ultrasonic welding machine. Thereafter, the top cover was joined using an adhesive in the same manner as in Example 1- (4). The molding conditions and evaluation results in Example 19 are shown in Table 6 below.

### (Reference Example 1)

Except that a reinforcing structure as described in Table 6 was molded and used, a liquid crystal display was provided as a top cover, the same procedure as in Example 2 was carried out to obtain a housing. The molding conditions and evaluation results in Reference Example 1 are shown in Table 6 below.

### (Comparative Example 1)

Except that a reinforcing structure was not used, the same procedure as in Example 1 was carried out to obtain a housing. The molding conditions and evaluation results in Comparative Example 1 are shown in Table 7 below.

### (Comparative Example 2)

Except that a laminate obtained by laminating material 1 and material 2 was used as a material of a bottom cover, the same procedure as in Comparative Example 1 was carried out to obtain a housing. The molding conditions and evaluation results in Comparative Example 2 are shown in Table 7 below.

### (Comparative Examples 3 and 4)

Except that a size as described in Table 7 was set, and members were joined on the plane, the same procedure as in Example 1 was carried out to obtain a housing. The molding conditions and evaluation results in Comparative Examples 3 and 4 are shown in Table 7 below.

### [Evaluation]

The housings obtained in examples were confirmed to exhibit high torsional rigidity. Among them, the housings of Examples 1 and 2 exhibited very high torsional rigidity, and also capable of mounting many electronic devices etc. in a hollow structure because the ratio of the hollow structure was high. Thus, the housings were suitable for thickness reduction and weight reduction. It was confirmed that in Example 7, not only torsional rigidity but also deflection rigidity was exhibited due to the effect of another reinforcing structure. Examples 2 to 19 are preferable from the viewpoint of repair and recycling because the top cover and the reinforcing structure are joined to each other by heat welding, and therefore the joining portion can be disassembled by heating while high torsional rigidity and deflection rigidity are exhibited. Examples 6 and 10 are preferable from the viewpoint of weight reduction because the reinforcing structure and the bottom cover are bonded directly to each other, and therefore an increase in weight is smaller as compared to a case where an adhesive or a hot melt resin is used.

In Examples 12 to 14, not only high torsional rigidity but also deflection rigidity was exhibited by using a metal material having high dynamic characteristics for the bottom cover. In addition, the metal material has a high thermal conductivity, and is therefore preferable from the viewpoint of thermal characteristics. Example 15 is preferable from the viewpoint of not only high torsional rigidity but also enabling radio wave communication because a non-conductive material having electromagnetic wave permeability is used for the bottom cover. Examples 17 and 18 are intended to reduce the thickness of each member, and thus contributes to weight reduction and thickness reduction of the housing while maintaining torsional rigidity. In Example 19, a resin material was used for each member, and it was confirmed that while having poor deflection rigidity, the housing exhibited torsional rigidity. In addition, Reference Example 1 was provided as a method for using a housing, where electronic components were disposed in a hollow structure to prepare an electronic device with a liquid crystal display used as a top cover. It was confirmed that when the requirements of the present invention were satisfied, it was possible to provide an electronic device exhibiting high torsional rigidity and deflection rigidity.

On the other hand, the housings of Comparative Examples 1 and 2 had very low resistance to torsion, so that there was the possibility of damaging internal electronic components. In Comparative Examples 3 and 4, a reinforcing structure was used, but the requirements of the present invention were not satisfied, and it was impossible to exhibit satisfactory torsional rigidity.

**[Table 2]**

| | | | Example 1 | Example 2 | Example 3 | Example 4 |
|---|---|---|---|---|---|---|
| Bottom cover: | | | | | | |
| | Material | - | Material 1 | Material 1 | Material 1 | Material 1 |
| | Length | mm | 210 | 210 | 210 | 210 |
| | Width | mm | 300 | 300 | 300 | 300 |
| | Height | mm | 10 | 10 | 10 | 10 |
| | Thickness | mm | 0.8 | 0.8 | 0.8 | 0.8 |
| | Projected area | cm² | 630 | 630 | 630 | 630 |
| | Volume | cm³ | 572 | 572 | 572 | 572 |

| Top cover: | | | | | | |
|---|---|---|---|---|---|---|
| | Material | - | Material 1 | Material 1 | Material 1 | Material 1 |
| | Length | mm | 210 | 210 | 210 | 210 |
| | Width | mm | 300 | 300 | 300 | 300 |
| | Height | mm | - | - | - | - |
| | Thickness | mm | 0.8 | 0.8 | 0.8 | 0.8 |
| | Projected area | cm² | 630 | 630 | 630 | 630 |
| | Volume | cm³ | - | - | - | - |

| Reinforcing structure: | | | | | | |
|---|---|---|---|---|---|---|
| | Material | - | Material 2 | Material 2 | Material 2 | Material 2 |
| | Length | mm | 208.4 | 208.4 | 208.4 | 208.4 |
| | Width | mm | 250 | 250 | 250 | 250 |
| | Height | mm | 8 | 8 | 5 | 3 |
| | Angle | ° | 90 | 90 | 90 | 90 |
| | Thickness | mm | 0.8 | 0.8 | 0.8 | 0.8 |
| | Overlap width | mm | 0 | 0 | 0 | 0 |
| | Bonding area | cm² | 40 | 40 | 25 | 15 |
| | Projected area | cm² | 521 | 521 | 521 | 521 |
| | Volume | cm³ | 370 | 370 | 216 | 113 |

| Another reinforcing structure | | | | | | |
|---|---|---|---|---|---|---|
| | Material | - | - | - | - | - |
| | Length | mm | - | - | - | - |
| | Width | mm | - | - | - | - |
| | Height | mm | - | - | - | - |

| Electronic device housing | | | | | | |
|---|---|---|---|---|---|---|
| | Projected area ratio | % | 82.7 | 82.7 | 82.7 | 82.7 |
| | Volume ratio | % | 64.6 | 64.6 | 37.7 | 19.8 |
| | Integration method | - | Adhesive | Thermal welding | Thermal welding | Thermal welding |
| | Bonding portion | - | Rising wall (long side) | Rising wall (long side) | Rising wall (long side) | Rising wall (long side) |
| | Peeling load (23°C) | N/cm² | 1500 | 2000 | 2500 | 2500 |
| | Peeling load (200°C) | N/cm² | 700 | 50 | 50 | 50 |

| Evaluation | | | | | | |
|---|---|---|---|---|---|---|
| | Torsional rigidity | - | ⊙ | ⊙ | ⊙ | ○ |
| | Deflection rigidity | - | ○ | ○ | ○ | ○ |

**[Table 3]**

| | | | Example 5 | Example 6 | Example 7 | Example 8 |
|---|---|---|---|---|---|---|
| Bottom cover: | | | | | | |
| | Material | - | Material 1 | Material 1 | Material 1 | Material 1 |
| | Length | mm | 210 | 210 | 210 | 210 |
| | Width | mm | 300 | 300 | 300 | 300 |
| | Height | mm | 10 | 10 | 10 | 10 |
| | Thickness | mm | 0.8 | 0.8 | 0.8 | 0.8 |
| | Projected area | cm² | 630 | 630 | 630 | 630 |
| | Volume | cm³ | 572 | 572 | 572 | 572 |

| Top cover: | | | | | | |
|---|---|---|---|---|---|---|
| | Material | - | Material 1 | Material 1 | Material 1 | Material 1 |
| | Length | mm | 210 | 210 | 210 | 210 |
| | Width | mm | 300 | 300 | 300 | 300 |
| | Height | mm | - | - | - | - |
| | Thickness | mm | 0.8 | 0.8 | 0.8 | 0.8 |
| | Projected area | cm² | 630 | 630 | 630 | 630 |
| | Volume | cm³ | - | - | - | - |

| Reinforcing structure: | | | | | | |
|---|---|---|---|---|---|---|
| | Material | - | Material 2 | Material 2 | Material 2 | Material 2 |
| | Length | mm | 180 | 208.4 | 208.4 | 208.4 |
| | Width | mm | 298.4 | 260 | 250 | 298.4 |
| | Height | mm | 8 | 8 | 8 | 8 |
| | Angle | ° | 90 | 90 | 90 | 90 |
| | Thickness | mm | 0.8 | 0.8 | 0.8 | 0.8 |
| | Overlap width | mm | 0 | 5 | 0 | 0 |
| | Bonding area | cm² | 29 | 83 | 40 | 81 |
| | Projected area | cm² | 537 | 542 | 521 | 622 |
| | Volume | cm³ | 381 | 385 | 370 | 442 |

| Another reinforcing structure | | | | | | |
|---|---|---|---|---|---|---|
| | Material | - | - | - | Material 1 | - |
| | Length | mm | - | - | 188 | - |
| | Width | mm | - | - | 3 | - |
| | Height | mm | - | - | 7.2 | - |

| Electronic device housing | | | | | | |
|---|---|---|---|---|---|---|
| | Projected area ratio | % | 85.3 | 86.0 | 82.7 | 98.7 |
| | Volume ratio | % | 66.6 | 67.2 | 64.6 | 77.2 |
| | Integration method | | Thermal welding | Thermal welding | Thermal welding | Thermal welding |
| | Bonding portion | - | Rising wall (short side) | Rising wall (long side) | Rising wall (long side) | Rising wall (four sides) |
| | Peeling load(23°C) | N/cm² | 2500 | 2500 | 2500 | 2500 |
| | Peeling load (200°C) | N/cm² | 50 | 50 | 50 | 50 |

| Evaluation | | | | | | |
|---|---|---|---|---|---|---|
| | Torsional rigidity | - | ○ | ⊙ | ⊙ | ⊙ |
| | Deflection rigidity | - | ○ | ○ | ⊙ | ○ |

**[Table 4]**

| | | | Example 9 | Example 10 | Example 11 | Example 12 |
|---|---|---|---|---|---|---|
| Bottom cover: | | | | | | |
| | Material | - | Material 1 | Material 1 | Material 1 | Material 3 |
| | Length | mm | 210 | 210 | 210 | 210 |
| | Width | mm | 300 | 300 | 300 | 300 |
| | Height | mm | 10 | 10 | 10 | 10 |
| | Thickness | mm | 0.8 | 0.8 | 0.8 | 0.6 |
| | Projected area | cm² | 630 | 630 | 630 | 630 |
| | Volume | cm³ | 572 | 572 | 572 | 586 |

| Top cover: | | | | | | |
|---|---|---|---|---|---|---|
| | Material | - | Material 1 | Material 1 | Material 1 | Material 1 |
| | Length | mm | 210 | 210 | 210 | 210 |
| | Width | mm | 300 | 300 | 300 | 300 |
| | Height | mm | - | - | - | - |
| | Thickness | mm | 0.8 | 0.8 | 0.8 | 0.8 |
| | Projected area | cm² | 630 | 630 | 630 | 630 |
| | Volume | cm³ | - | - | - | - |

| Reinforcing structure: | | | | | | |
|---|---|---|---|---|---|---|
| | Material | - | Material 2 | Material 2 | Material 2 | Material 2 |
| | Length | mm | 180 | 180 | 208.4 | 208.4 |
| | Width | mm | 250 | 250 | 250 | 250 |
| | Height | mm | 9.2 | 9.2 | 9.2 | 8 |
| | Angle | ∘ | 90 | Acute angle | 90 | 90 |
| | Thickness | mm | 0.8 | 0.8 | 0.8 | 0.8 |
| | Overlap width | mm | 0 | 5 | 0 | 0 |
| | Bonding area | cm² | 561 | 561 | 561 | 40 |
| | Projected area | cm² | 450 | 450 | 521 | 521 |
| | Volume | cm³ | 372 | 372 | 432 | 370 |

| Another reinforcing structure | | | | | | |
|---|---|---|---|---|---|---|
| | Material | - | - | - | - | - |
| | Length | mm | - | - | - | - |
| | Width | mm | - | - | - | - |
| | Height | mm | - | - | - | - |

| Electronic device housing | | | | | | |
|---|---|---|---|---|---|---|
| | Projected area ratio | % | 71.4 | 71.4 | 82.7 | 82.7 |
| | Volume ratio | | 65.1 | 65.1 | 75.4 | 63.1 |
| | Integration method | | Thermal welding | Thermal welding | Thermal welding | Thermal welding |
| | Bonding portion | | Plane | Plane | Rising wall, Plane | Rising wall (long side) |
| | Peeling load (23°C) | N / cm² | 2500 | 2500 | 2500 | 2500 |
| | Peeling load (200°C) | N/cm² | 50 | 50 | 50 | 50 |

| Evaluation | | | | | | |
|---|---|---|---|---|---|---|
| | Torsional rigidity | - | ⊙ | ○ | ⊙ | ⊙ |
| | Deflection rigidity | - | ○ | ⊙ | ⊙ | ⊙ |

**[Table 5]**

| | | | Example 13 | Example 14 | Example 15 | Example 16 |
|---|---|---|---|---|---|---|
| Bottom cover: | | | | | | |
| | Material | - | Material 4 | Material 5 | Material 2 | Material 1 |
| | Length | mm | 210 | 210 | 210 | 210 |
| | Width | mm | 300 | 300 | 300 | 300 |
| | Height | mm | 10 | 10 | 10 | 10 |
| | Thickness | mm | 0.8 | 0.2 | 0.8 | 0.8 |
| | Projected area | cm² | 630 | 630 | 630 | 630 |
| | Volume | cm³ | 572 | 615 | 572 | 572 |

| Top cover: | | | | | | |
|---|---|---|---|---|---|---|
| | Material | - | Material 1 | Material 1 | Material 1 | Material 1 |
| | Length | mm | 210 | 210 | 210 | 210 |
| | Width | mm | 300 | 300 | 300 | 300 |
| | Height | mm | - | - | - | - |
| | Thickness | mm | 0.8 | 0.8 | 0.8 | 0.8 |
| | Projected area | cm² | 630 | 630 | 630 | 630 |
| | Volume | cm³ | - | - | - | - |

| Reinforcing structure: | | | | | | |
|---|---|---|---|---|---|---|
| | Material | - | Material 2 | Material 2 | Material 2 | Material 1 |
| | Length | mm | 208.4 | 208.4 | 208.4 | 208.4 |
| | Width | mm | 250 | 250 | 250 | 250 |
| | Height | mm | 8 | 8 | 8 | 8 |
| | Angle | _{°} | 90 | 90 | 90 | 90 |
| | Thickness | mm | 0.8 | 0.8 | 0.8 | 0.8 |
| | Overlap width | mm | 0 | 0 | 0 | 0 |
| | Bonding area | cm² | 40 | 40 | 40 | 40 |
| | Projected area | cm² | 521 | 521 | 521 | 521 |
| | Volume | cm³ | 370 | 370 | 370 | 370 |

| Another reinforcing structure | | | | | | |
|---|---|---|---|---|---|---|
| | Material | - | - | - | - | - |
| | Length | mm | - | - | - | - |
| | Width | mm | - | - | - | - |
| | Height | mm | - | - | - | - |

| Electronic device housing | | | | | | |
|---|---|---|---|---|---|---|
| | Projected area ratio | % | 82.7 | 82.7 | 82.7 | 82.7 |
| | Volume ratio | % | 64.6 | 60.1 | 64.6 | 64.6 |
| | Integration method | | Thermal welding | Thermal welding | Thermal welding | Thermal welding |
| | Bonding portion | - | Rising wall (long side) | Rising wall (long side) | Rising wall (long side) | Rising wall (long side) |
| | Peeling load(23°C) | N/cm² | 2500 | 2500 | 2500 | 2500 |
| | Peeling load(200°C) | N/cm² | 50 | 50 | 50 | 50 |

| Evaluation | | | | | | |
|---|---|---|---|---|---|---|
| | Torsional rigidity | - | ○ | ○ | ⊙ | ⊙ |
| | Deflection rigidity | - | ○ | ○ | ○ | ○ |

**[Table 6]**

| | | | Example 17 | Example 18 | Example 19 | Reference Example 1 |
|---|---|---|---|---|---|---|
| Bottom cover: | | | | | | |
| | Material | - | Material 1 | Material 1 | Material 6 | Material 1 |
| | Length | mm | 210 | 210 | 210 | 180 |
| | Width | mm | 300 | 300 | 300 | 230 |
| | Height | mm | 10 | 10 | 10 | 7 |
| | Thickness | mm | 0.4 | 0.8 | 0.8 | 0.8 |
| | Projected area | cm² | 630 | 630 | 630 | 414 |
| | Volume | cm³ | 601 | 572 | 572 | 253 |

| Top cover: | | | | | | |
|---|---|---|---|---|---|---|
| | Material | - | Material 1 | Material 1 | Material 6 | Display |
| | Length | mm | 210 | 210 | 210 | 210 |
| | Width | mm | 300 | 300 | 300 | 300 |
| | Height | mm | - | - | - | - |
| | Thickness | mm | 0.6 | 0.8 | 0.8 | 0.8 |
| | Projected area | cm² | 630 | 630 | 630 | 630 |
| | Volume | cm³ | - | - | - | - |

| Reinforcing structure: | | | | | | |
|---|---|---|---|---|---|---|
| | Material | - | Material 2 | Material 2 | Material 6 | Material 2 |
| | Length | mm | 208.4 | 208.4 | 208.4 | 209 |
| | Width | mm | 250 | 250 | 250 | 180 |
| | Height | mm | 8 | 8 | 8 | 5 |
| | Angle | ∘ | 90 | 90 | 90 | 90 |
| | Thickness | mm | 0.8 | 0.4 | 0.8 | 0.5 |
| | Overlap width | mm | 0 | 0 | 0 | 0 |
| | Bonding area | cm² | 40 | 40 | 40 | 18 |
| | Projected area | cm² | 521 | 521 | 521 | 376 |
| | Volume | cm³ | 370 | 393 | 370 | 168 |

| Another reinforcing structure | | | | | | |
|---|---|---|---|---|---|---|
| | Material | - | - | - | - | - |
| | Length | mm | - | - | - | - |
| | Width | mm | - | - | - | - |
| | Height | mm | - | - | - | - |

| Electronic device housing | | | | | | |
|---|---|---|---|---|---|---|
| | Projected area ratio | % | 82.7 | 82.7 | 82.7 | 90.9 |
| | Volume ratio | % | 61.6 | 68.7 | 64.6 | 66.3 |
| | Integration method | - | Thermal welding | Thermal welding | Heating platen welding | Thermal welding |
| | Bonding portion | - | Rising wall (long side) | Rising wall (long side) | Rising wall (long side) | Rising wall (long side) |
| | Peeling load (23°C) | N/cm² | 2500 | 2500 | 2500 | 2500 |
| | Peeling load (200°C) | N/cm² | 50 | 50 | 50 | 50 |

| Evaluation | | | | | | |
|---|---|---|---|---|---|---|
| | Torsional rigidity | - | ○ | ⊙ | ○ | ⊙ |
| | Deflection rigidity | - | Δ | ○ | Δ | ○ |

**[Table 7]**

| | | | Comparative Example 1 | Comparative Example 2 | Comparative Example 3 | Comparative Example 4 |
|---|---|---|---|---|---|---|
| Bottom cover: | | | | | | |
| | Material | - | Material 1 | Material 1/ Material 2 | Material 1 | Material 1 |
| | Length | mm | 210 | 210 | 210 | 210 |
| | Width | mm | 300 | 300 | 300 | 300 |
| | Height | mm | 10 | 10 | 10 | 10 |
| | Thickness | mm | 0.8 | 1.6 | 0.8 | 0.8 |
| | Projected area | cm² | 630 | 630 | 630 | 630 |
| | Volume | cm³ | 572 | 516 | 572 | 572 |

| Top cover: | | | | | | |
|---|---|---|---|---|---|---|
| | Material | - | Material 1 | Material 1 | Material 1 | Material 1 |
| | Length | mm | 210 | 210 | 210 | 210 |
| | Width | mm | 300 | 300 | 300 | 300 |
| | Height | mm | - | - | - | - |
| | Thickness | mm | 0.8 | 0.8 | 0.8 | 0.8 |
| | Projected area | cm² | 630 | 630 | 630 | 630 |
| | Volume | cm³ | - | - | - | - |

| Reinforcing structure: | | | | | | |
|---|---|---|---|---|---|---|
| | Material | - | - | - | Material 2 | Material 2 |
| | Length | mm | - | - | 100 | 100 |
| | Width | mm | - | - | 200 | 200 |
| | Height | mm | - | - | 2 | 8 |
| | Angle | ∘ | - | - | 90 | 90 |
| | Thickness | mm | - | - | 1 | 1 |
| | Overlap width | mm | - | - | 0 | 0 |
| | Bonding area | cm² | - | - | 6 | 6 |
| | Projected area | cm² | - | - | 200 | 200 |
| | Volume | cm³ | - | - | 19 | 136 |

| Another reinforcing structure | | | | | | |
|---|---|---|---|---|---|---|
| | Material | - | - | - | - | - |
| | Length | mm | - | - | - | - |
| | Width | mm | - | - | - | - |
| | Height | mm | - | - | - | - |

| Electronic device housing | | | | | | |
|---|---|---|---|---|---|---|
| | Projected area ratio | % | 0.0 | 0.0 | 31.7 | 31.7 |
| | Volume ratio | % | 0.0 | 0.0 | 3.4 | 23.7 |
| | Integration method | - | - | - | Adhesive | Adhesive |
| | Bonding portion | - | - | - | Plane | Plane |
| | Peeling load (23°C) | N/cm² | - | - | 1500 | 1500 |
| | Peeling load (200°C) | N/cm² | - | - | 700 | 700 |

| Evaluation | | | | | | |
|---|---|---|---|---|---|---|
| | Torsional rigidity | - | × | × | × | × |
| | Deflection rigidity | - | × | ○ | × | × |

### INDUSTRIAL APPLICABILITY

According to the present invention, there can be provided a housing having improved torsional rigidity while having a reduced thickness and weight and improved portability.

### DESCRIPTION OF REFERENCE SIGNS

1: Housing
2: Bottom cover
3: Reinforcing structure
4: Top cover
5: Another reinforcing structure
21: Flat portion
22: Rising wall member
31: Flat portion
32: Rising wall member

## Claims

1. A housing comprising: a bottom cover; a top cover; and a reinforcing structure that is disposed in a space divided by the bottom cover and the top cover, and has a flat portion, and a rising wall member erected on a rim of the flat portion,
wherein
the rising wall member of the reinforcing structure is joined to a rising wall member erected on a rim of the bottom cover or the top cover.

2. The housing according to claim 1,
wherein the rim of the reinforcing structure is joined to the bottom cover or the top cover, and at least a part of a region other than the rim of the reinforcing structure is joined to the bottom cover or the top cover to which the rim of the reinforcing structure is not joined.

3. A housing comprising: a bottom cover; a top cover; and a reinforcing structure that is disposed in a space divided by the bottom cover and the top cover, and has a flat portion, and a rising wall member erected on a rim of the flat portion,
wherein
the rim of the reinforcing structure is joined to the bottom cover or the top cover, and at least a part of a region other than the rim of the reinforcing structure is joined to the bottom cover or the top cover to which the rim of the reinforcing structure is not joined.

4. The housing according to any one of claims 1 to 3,
wherein the reinforcing structure is bonded to the bottom cover and/or the top cover by thermal welding.

5. The housing according to any one of claims 1 to 4,
wherein the reinforcing structure is joined to the bottom cover and/or the top cover in such a manner that the peeling load at 23°C is within a range of 60 N/cm² or more and 5000 N/cm² or less, and the peeling load at 200°C is within a range of less than 60 N/cm².

6. The housing according to any one of claims 1 to 5,
wherein the reinforcing structure, and the bottom cover and/or the top cover to which the reinforcing structure is joined are formed of a fiber-reinforced composite material, a thermoplastic resin is provided in or on a joining portion of at least one of the reinforcing structure and the bottom cover and/or the top cover, and the reinforcing structure and the bottom cover and/or the top cover are joined with the thermoplastic resin.

7. The housing according to any one of claims 1 to 6,
wherein the reinforcing structure is joined directly to the bottom cover and/or the top cover.

8. The housing according to any one of claims 1 to 7, comprising a heat generation member disposed on a surface of the reinforcing structure in the hollow structure formed by joining the reinforcing structure and the bottom cover and/or the top cover.

9. The housing according to any one of claims 1 to 8, comprising another reinforcing structure in the hollow structure formed by joining the reinforcing structure and the bottom cover and/or the top cover.

10. The housing according to claim 9,
wherein the other reinforcing structure is joined to the inner surface of the reinforcing structure, and the bottom cover or the top cover to which the reinforcing structure is joined.
